# EUROPEAN PATENT APPLICATION

(11) **EP 1 414 079 A1**
(43) Date of publication of application: **28.04.2004**
(21) Application number: 02755764.4
(22) Date of filing: 01.08.2002
(51) Int. Cl.: H01L 33/00, H01S 5/32

(54) **DIAMOND HIGH BRIGHTNESS ULTRAVIOLET RAY EMITTING ELEMENT**

(30) Priority: 03.08.2001 JP 2001236938
(71) Applicant: Tokyo Gas Co., Ltd., Tokyo 105-8527 (JP)
(72) Inventor: HORIUCHI, Kenji, Minato-ku, Tokyo 105-8527 (JP); NAKAMURA, Kazuo, Minato-ku, Tokyo 105-8527 (JP); ISHIKURA, Takefumi, Minato-ku, Tokyo 105-8527 (JP); NAGAI, Masaya, Bunkyo-ku, Tokyo 113-8656 (JP); SHIMANO, Ryo, Bunkyo-ku, Tokyo 113-8656 (JP); GONOKAMI, Makoto, Bunkyo-ku, Tokyo 113-8656 (JP)
(74) Representative: Schumacher & Willsau
(86) International application number: PCT/JP2002/007873
(87) International publication number: WO 2003/015184

(57) **Abstract**

A diamond high brightness ultraviolet ray emitting element employs the carrier high-density phase of a diamond as a light-emitting mechanism. It includes a diamond substrate (1), a first diamond layer (2) formed on the diamond substrate (1), a second diamond layer (3) formed on the first diamond layer (2) and functioning as an emission layer, a third diamond layer (4) formed on the second diamond layer (3), a first electrode (7) formed on the first diamond layer (2), and a second electrode (8) formed on the third diamond layer (4). The second diamond layer (3) constitutes the carrier high-density phase formed by high-density excitation. The combination of the high-density excitation with the high-quality diamond can implement the device that has stable carrier high-density phase, and emission efficiency higher than a conventional device with low-density excitation.

## Description

### TECHNICAL FIELD

The present invention relates to a diamond high brightness ultraviolet ray emitting element, and more particularly to a diamond high brightness ultraviolet ray emitting element that employs the carrier high-density phase of a diamond as a light-emitting mechanism.

### BACKGROUND ART

The intrinsic photoemission of a diamond is generally in an ultraviolet region with a wavelength from 230 to 250 nm, and is applied to ultraviolet EL devices. In particular, as for the devices utilizing the free exciton recombination radiation, Japanese patent application laid-open Nos. 2000-340837 and 2000-349330 disclose them.

Japanese patent application laid-open No. 2000-340837 discloses a technique of fabricating a current injection excitation light-emitting device, in which the free exciton recombination radiation with a short wavelength unique to the diamond is dominant, by using a vapor phase synthetic diamond. On the other hand, Japanese patent application laid-open No. 2000-349330 discloses a technique of fabricating a current injection excitation light-emitting device, in which the free exciton recombination radiation with a short wavelength unique to the diamond is dominant, by using a diamond MIS (Metal-Insulator-Semiconductor) structure.

In addition, as for conventional examples of diamond lasers, Japanese patent application laid-open Nos. 6-097540 (1994) and 11-298085 (1999) disclose them. Japanese patent application laid-open No. 6-097540 (1994) discloses a solid laser oscillating in an ultraviolet region. It employs a diamond crystal as a laser emission medium, and emits a laser beam with a wavelength equal to or greater than 225 nm and equal to or less than 300 nmby the exciton radiation. On the other hand, Japanese patent application laid-open No. 11-298085 (1999) discloses an ultraviolet laser device generating a laser beam with a short wavelength equal to or less than 300 nm. It comprises a first electrode, a first diamond layer formed on the first electrode, an emission layer composed of a boron-doped diamond formed on the first diamond layer, a second diamond layer formed on the emission layer, a second electrode formed on the second diamond layer, and a power supply connected across the first electrode and the second electrode, in which the first diamond layer and second diamond layer have a resistance higher than the emission layer.

The foregoing documents, however, do not discuss the light-emitting mechanism and the method of utilizing it, which is essential for diamond high brightness emitting element in general, and for the laser device in particular. Specifically, although the diamond with excellent crystallinity exhibits emission called exciton radiation in response to a variety of excitations, it is impossible to expect the exciton radiation to bring about very high efficient emission, particularly laser oscillation. On the other hand, it is known that high-density excitation of the diamond causes the exciton to be dissociated into plasma called a high-density phase. However, a method of applying it to real devices or its precise characteristics are not known.

This will be described in more detail.

In the foregoing conventional examples, the diamond crystal with high crystallinity and limited impurity concentration causes light emission called exciton radiation by excitation by an electron beam or carrier injection. The term "exciton" refers to a state where pairs of electrons and holes generated by a variety of excitations are present in the crystal. The electrons and holes constituting the excitons emit light when they are recombined. The wavelength of the exciton radiation is determined by the crystal temperature and impurity. For example, the free exciton at room temperature exhibits the light emission having a principal peak at 235 nm and secondary peaks at 242 nm, 249 nm and so on. However, as for the diamond with an indirect band gap structure, since the exciton radiation is also indirect transition, high emission efficiency cannot be expected. In addition, because it has no optical gain in principle, the laser oscillation cannot be implemented.

In summary, the low-density excitation of a high-quality diamond crystal can bring about the exciton radiation. In contrast, in the high-density excitation of a diamond with a carrier density beyond 10²⁰ cm⁻³, the exciton can no longer maintain the pair state, thereby being dissociatedintoplasma (K. Thonke, R. Schliesing, N. Teolov, H. Zacharias, R. Sauer, A. M. Zaitsev, H. Kanda, and T. R. Anthony, Diamond Related Materials, vol. 9, p. 428 (2000)). The high-density phase assumes a form called electron-hole plasma (EHP), part of which is condensed to liquid at a temperature equal to or lower than 170 K, thereby making a phase transition to electron-hole droplets (EHD), and exhibiting unique light emission characteristics. In the specification, the EHP and EHD are generically called a carrier high-density phase of a diamond. As for the high-density phase, however, its emission characteristics have not yet disclosed except for its spectrum up to now, much less its application methods to devices.

For example, as an excitation method of bringing about the exciton radiation, Japanese patent application laid-open No. 6-097540 (1994) discloses a method of injecting carriers into a diamond by applying electric field to an electric junction provided in the diamond such as a MIS junction and heterojunction. Although it describes that powerful excitation equal to or greater than 0.1 W/cm² is carried out, the excitation intensity is not enough to achieve the high-density phase. In addition, although it describes that a low temperature equal to or lower than the liquid nitrogen temperature (77 K) is preferable, since the emission efficiency of the high-density phase (EHD, in this case) is reduced, a temperature of about 130 K or higher is favorable. Furthermore, although it states that about 0.02 second irradiation of an electron beam with an acceleration voltage of 25 KV and a current of 0.6 mA is repeated at one second intervals for a 7 × 3 mm² plane, the current density for the excitation is 0.03 Acm⁻², which is insufficient to implement the carrier high-density phase. Moreover, although it employs an Ib-type diamond single crystal including nitrogen and boron of about 25 ppm in average in the embodiments, since the nitrogen concentration in the crystal is too high, it has a problem of being unable to use the carrier high-density phase as the light-emitting mechanism.

Japanese patent application laid-open No. 11-298085 (1999) discloses a combination of a MIS structure laser, which emits light at a wavelength equal to or less than 300 nm, with an electrode buffer insulating layer. The electrode buffer insulating layer is used for reducing crystal defects to improve the exciton radiation intensity rather than for constituting a structure for implementing the high-density phase. In addition, since the diamond has an indirect band structure, following the conventional structure only, which is composed of direct band gap materials (cavity + cooler + excitation method), cannot achieve the highly efficient light-emitting device, particularly the laser device.

In view of the foregoing problems, the present invention is implemented by studying the characteristics of the diamond high-density phase in detail by a unique method. More specifically, we discovered that the diamond high-density phase has high emission efficiency. In particular, as for the intrinsic photoemission of an indirect band gap semiconductor, we discovered the optical gain of the high-densityphase for the first time, and applied it to an optical gain mechanism in the diamond ultraviolet laser.

Therefore an object of the present invention is to provide a diamond high brightness ultraviolet ray emitting element utilizing the diamond high-density phase having the excellent characteristics as the light-emitting mechanism.

### DISCLOSURE OF THE INVENTION

To accomplish the foregoing object, according to an aspect of the present invention, there is provided a a diamond high brightness ultraviolet ray emitting element comprising as a light-emitting mechanism a carrier high-density phase which is formed by subjecting a diamond crystal to high-density excitation. Here, the diamond high brightness ultraviolet ray emitting element is a term including both the emitting element (such as an LED) using spontaneous emission, and a laser device using stimulated emission.

According to an aspect of the present invention, the high-density excitation has an intensity equal to or greater than 10²⁰ cm⁻³ in terms of a carrier density, or equal to or greater than 100 Acm⁻² in terms of a current density.

According to an aspect of the present invention, a region for carrying out the high-density excitation is spatially limited to an area equal to or less than 0.01 cm².

According to an aspect of the present invention, the region for carrying out the high-density excitation is formed by etching.

According to an aspect of the present invention, the spatial restriction of the region for carrying out the high-density excitation is formed by diamond isolated particle.

According to an aspect of the present invention, further comprises a structure for controlling temperature equal to or lower than 170 Kwhen using electron-hole droplets, and equal to or higher than 160 K when using electron-hole plasma.

According to an aspect of the present invention, further comprises a spatial confinement structure of the carriers.

According to an aspect of the present invention, the spatial confinement structure of the carriers comprises a stackof layers including at least two layers with different electric characteristics.

According to an aspect of the present invention, the spatial confinement structure of the carriers comprises one of a pn junction and a pin junction.

According to an aspect of the present invention, the one of the pn junction and the pin junction comprises a p-type layer composed of a boron-doped diamond.

According to an aspect of the present invention, the one of the pn junction and the pin junction comprises an n-type layer composed of a phosphorus-doped diamond or sulfur-doped diamond.

According to an aspect of the present invention, the one of the pn junction and the pin junction comprises electrodes formed on the p-type layer and the n-type layer.

According to an aspect of the present invention, the electrodes are composed of titanium.

According to an aspect of the present invention, isotope composition ratio of at least part of the diamond is controlled.

According to an aspect of the present invention, purity of ¹²C or ¹³C is controlled equal to or greater than 90% in the control of the isotope composition ratio of the diamond.

According to an aspect of the present invention, the confinement structure is formed by introducing crystal defects into a region of the crystal by at least one of methods consisting of an impurity doping, neutron beam irradiation, and distortion introduction.

According to an aspect of the present invention, comprises a diamond substrate that functions as a heat sink.

According to an aspect of the present invention, the diamond crystal has a nitrogen concentration equal to or less than 10 ppm.

According to an aspect of the present invention, the diamond crystal has a boron concentration equal to or less than 100 ppm.

According to an aspect of the present invention, further comprises an optical cavity, and operates as a laser.

According to an aspect of the present invention, a reflection wavelength of reflecting mirrors constituting the optical cavity, and a cavity length are optimized for an emission wavelength of EHD or EHP.

According to an aspect of the present invention, the optical cavity comprises reflecting mirror planes formed by etching.

According to an aspect of the present invention, the optical cavity comprises reflecting mirror planes formed by a (111) cleaved plane.

According to an aspect of the present invention, the optical cavity comprises reflecting mirror planes formed by naturally formed plane of isolated particles.

According to an aspect of the present invention, the cavity is composed of micro-spheres.

According to an aspect of the present invention, the optical cavity comprises reflecting mirrors composed of an Al film.

According to an aspect of the present invention, the optical cavity comprises reflecting mirrors composed of a dielectric multilayer film.

According to an aspect of the present invention, there is provided a bactericidal lamp that employs the diamond high brightness ultraviolet ray emitting element as a light source.

According to an aspect of the present invention, there is provided a lighting system that employs the diamond high brightness ultraviolet ray emitting element as a pumping source for fluorescent materials.

According to an aspect of the present invention, there is provided an optical disk drive that employs the diamond high brightness ultraviolet ray emitting element as a light source for reading information.

According to an aspect of the present invention, there is provided a semiconductor lithography system that employs the diamond high brightness ultraviolet ray emitting element as an exposure light source.

According to an aspect of the present invention, there is provided a semiconductor pattern test system that employs the diamond high brightness ultraviolet ray emitting element as a light source.

According to an aspect of the present invention, there is provided a medical laser scalpel system that employs the diamond high brightness ultraviolet ray emitting element as a light source.

According to the present invention, the combination of the high-density excitation with the high-quality diamond can implement the device that has stable carrier high-density phase, and emission efficiency higher than a conventional device with low-density excitation.

Here, the term "high-density excitation" refers to the excitation that implements in the device the carrier density exceeding 10²⁰ cm⁻³ locally, which corresponds to the excitation density corresponding to a large current equal to or greater than 100 Acm⁻².

In addition, the term "high-quality diamond" refers to a crystal with little enough defects or unintended impurities, and exhibits clear free exciton recombination radiation by low-density excitation under the room temperature. In other words, the nitrogen concentration of the diamond crystal is equal to or less than 10 ppm, and the boron concentration is equal to or less than 100 ppm.

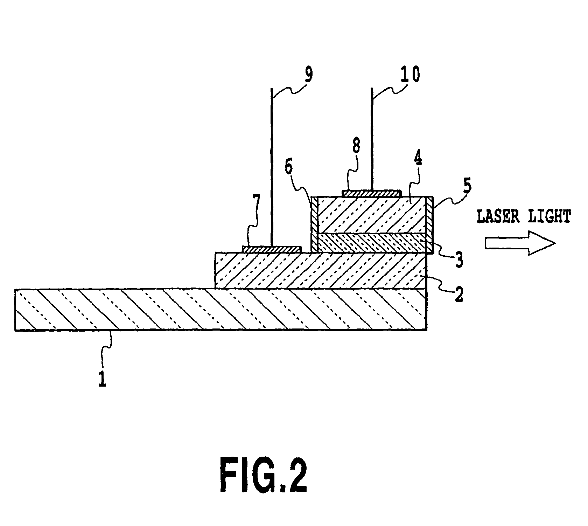

As for a concrete structure of the device, main operation conditions of the device must satisfy the excitation density and temperature that enable the high-density phase to exist stably as will be described below in connection with Fig.2. In other words, the intensity of the high-density excitation is equal to or greater than 10²⁰ cm⁻³ in terms of the carrier density, or equal to or greater than 100 Acm⁻² in terms of the current density. In addition, as for the optimized temperature, the EHD must become high-density phase at a temperature equal to or lower than 170 K, and the EHP must become high-density phase at a temperature equal to or higher than 160 K. Furthermore, the diamond substrate must function as a heat sink by itself.

### BRIEF DESCRIPTION OF THE DRAWINGS

Fig.1 is a graph illustrating photoluminescence spectra of a diamond at high-density excitations;
Fig.2 is a cross-sectional view showing an example of the diamond high brightness ultraviolet ray emitting element in accordance with the present invention;
Fig.3 is a graph illustrating current-emission intensity characteristics of the embodiment 1 of the diamond high brightness ultraviolet ray emitting element; and
Fig.4 is a cross-sectional view showing another embodiment of the diamond high brightness ultraviolet ray emitting element in accordance with the present invention.

### BEST MODE FOR CARRYING OUT THE INVENTION

The best mode for carrying out the invention will now be described with reference to the accompanying drawings.

As described above, we studied the light-emitting mechanism of the diamond, and discovered that when the high-density excitation of a high-quality diamond is performed, the carrier high-density phase continues a stable state, and exhibits high emission efficiency.

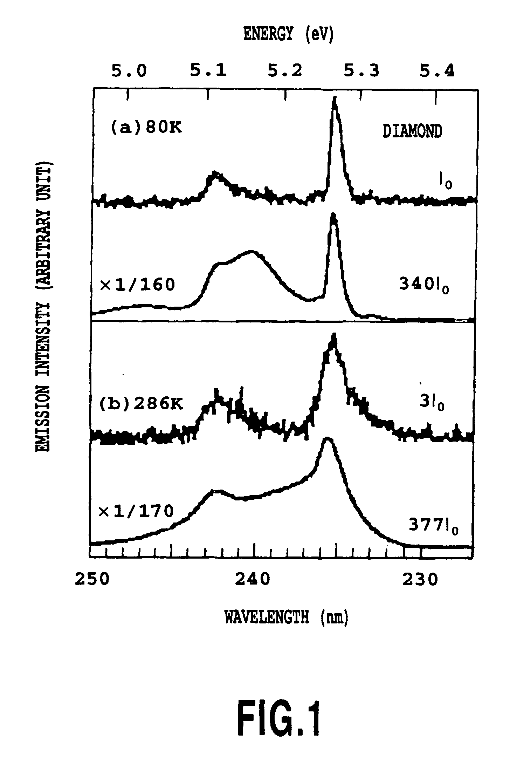

Fig.1 is a graph illustrating spectra of the high-density excitation photoluminescence of the diamond. The upper section (a) illustrates the measurement results carried out at a temperature 80 K, and the lower section (b) illustrates the measurement results at a temperature 286 K. Both the sections (a) and (b) show the free exciton recombination radiation having peaks at 235 nm and 242 nm when the excitation intensity is low such as (I₀, 3I₀). In contrast, when the high-density excitation is carried out at (340I₀, 377I₀) by increasing the excitation intensity, it is seen that an emission band appears between the two peaks. In this case, a pulse laser with a wavelength of 202 nm is used as the pumping source, and I₀ = 0.12 mJcm⁻².

The new emission band is formed when the free exciton is dissociated in a high-density excitation, and causes a phase transition to the plasma. Since the temperature is high in the case of (b), the state becomes electron-hole plasma (EHP). In contrast, in the case of (a), in which the temperature is low, the plasma is condensed and stays in the electron-hole droplets (EHD). Although it was difficult to accurately determine the boundary temperature at which the EHP was changed to the EHD because of errors in the measurements, the inventors discovered that the EHD were present at a temperature equal to or lower than about 170 K, and the EHP was present at a temperature equal to or higher than about 160 K. We confirmed that the threshold value of the carrier density at which the EHP/EHD were formed was 1 × 10²⁰ cm⁻³. The carrier density is considered to be the lowest value necessary for applying the EHP or EHD to the light-emitting mechanism of the emitting element.

The inventors of the present invention discovered for the first time that the high-density phase had an optical gain due to stimulated emission. The following two reasons are considered possible. The first lies in that since the diamond has a wide gap of about 5.5 eV, it has a large luminous coupling constant, and the absorption by the EHP or EHD is small. The second lies in that a new absorption band is formed because of the interaction between the excitons in the high-density phase, and hence the stimulated emission coefficient increases. As a result, the conventional common sense that an indirect band gap semiconductor cannot constitute a laser is overthrown.

Requirements for implementing the ultraviolet emitting element and laser device utilizing the high-density phase of the diamond exciton as the light-emitting mechanism will be described below.

### <Excitation Intensity>

The carrier density is set at a value equal to or greater than 10²⁰ cm⁻³, or the current density is set at a value equal to or greater than 100 Acm⁻². It is aminimum excitation density required for the free exciton of the diamond to change into the high-density phase. In addition, the current density is a minimum value required to achieve the carrier density.

### <Restrict Excitation Region Spatially>

The injectable excitation energy has its limit in practice. In addition, since the device generates heat because of the high energy excitation, the temperature control becomes difficult. Accordingly, it is necessary to limit the excitation space to carry out the high-density excitation.
(1) It is preferable that the excitation region be equal to or less than 0.01 cm⁻². This is because it is preferable that the driving current be about 1 A because of the constraints on the performance and cost of a power supply unit, and it is necessary for the area of the excitation region to be equal to or less than 0.01 cm⁻² to achieve the excitation equal to or greater than 100 Acm⁻² at that current.
(2) The excitation region is formed by etching. The limit on the excitation region can be implemented by forming a mesa structure by etching. As a method of etching, reactive ion etching (RIE), electron beam etching, ion beam etching and laser etching are available.
(3) The excitation region can be limited using diamond isolated particles. The isolated particle refer to diamond fine particles with a size equal to or less than 100 µm formable by vapor deposition. For example, Japanese patent application laid-open No. 9-059091 (1997) discloses a fabrication method of the diamond isolated particle with naturally formed plane.

### <Optimization of Temperature>

The high-density phase has different modes of EHD/EHP depending on the temperature, and varies its emission characteristics with the operation wavelength. Accordingly, the temperature of the diamond medium must be controlled accurately.
(1) The EHD optimum temperature is set at 170 K or lower. It is the optimum temperature of EHD.
(2) The EHP optimum temperature is set at 160 K or lower. It is the optimum temperature of EHP.

### <Provide Spatial Confinement Structure of Carriers>

To apply the high-density phase to the light-emitting mechanism, it is preferable to provide the spatial confinement structure of the carriers.

### <Confinement Structure>

(1) The confinement structure has a stack structure including at least two layers with different electric characteristics. A diode structure is suitable as an electric structure for implementing the high-density phase. In particular, a pn junction or pin junction is available as a high quality confinement structure.
(2) Boron (B) is used as a p-type dopant. As a method of forming a p-type diamond, a boron doping or surface termination with hydrogen is known. As a method of forming a high quality p-type diamond, the boron doping is preferable.
(3) Phosphorus (P) or sulfur (S) is used as an n-type dopant. As a method of forming an n-type diamond, the doping of the phosphorus, sulfur or lithium (Li) is known. To achieve a high quality n-type diamond, the doping of the phosphorus or sulfur is preferable.
(4) To carry out the excitation by the current injection, the p-type region and n-type region of the pn or pin junction are provided with electrodes. As the material of the electrodes, Ti is preferable because it can readily form an ohmic contact with the diamond.

### <Control of Isotope composition ratio of at Least One of Multiple Layers>

(1) It is known about the diamond that varying the isotope composition ratio of the carbon, the constituent atom of the diamond, changes its thermal conductivity and band gap (Refer to A. T. Collins, S. C. Lawson, G. Davies andH. Kanda, Physical Review Letter, vol. 65, p. 891(1990)). Accordingly, a combination of a plurality of layers with different isotope composition ratio is applicable to a spatial confinement structure of the carriers.
(2) The isotope composition ratio control is made so that the purity of ¹²C or ¹³C becomes equal to or greater than 90%. To increase a band gap difference between the layers, it is preferable that the purity of the ¹²C or ¹³C be set large. In addition, it is preferable that the purity of the ¹²C or ¹³C be set high because the thermal conductivity of the diamond must be kept high from the viewpoint of the temperature control.

### <Confinement Structure>

Defects are intentionally introduced into part of the device constituent crystal. As the spatial confinement structure of the carriers, particularly as a seed of generating the EHD, it is possible to introduce a trace of the crystal defects under intentional control of them and to utilize their characteristics.
(1) The crystal defects can be introduced by impurity doping.
(2) The crystal defects can be introduced by neutron beam irradiation.
(3) The crystal defects can be introduced by distorting the crystal by applying stress thereon.

### <Diamond Substrate Itself Functions as Heat Sink>

The temperature control is important to use the high-density phase as the light-emitting mechanism. For this purpose, it is preferable to utilize the diamond, which has the highest thermal conductivity in all the materials in the room temperature, as a heat sink.

### <Requirements for Crystal Quality>

Since the impurities in the crystal impair the formation and light emission of the carrier high-density phase, it is preferable that the impurity concentration in the crystal be as low as possible. However, since the dopant is necessary to achieve the electrical conductivity, the impurity concentration is determined according to the tradeoff between them.
(1) The nitrogen concentration of the crystal is set at 10 ppm or less. Since the nitrogen does nothing but impairs the light emission of the excitonhigh-densityphase, it is preferable that its concentration be as low as possible. We found from the results of the experiment and study that the threshold value was 10 ppm.
(2) The boron concentration of the crystal is set at 100 ppm or less. Although the high concentration dopant impairs the light emission of the high-density phase, it is necessary for the control of the electrical characteristics. We found from the results of the experiment and study that the boron concentration up to 100 ppm can achieve the light emission of the high-density phase, thereby determining the upper limit value.

### <Optimization of Cavity>

The high-density phase assumes different modes of EHD/EHP depending on the temperature, and its emission characteristics such as the operation wavelength vary. Accordingly, the cavity in the laser device must be optimized as needed.
(1) The reflecting mirror reflection wavelength is optimized to the EHD wavelength. The cavity length d is determined at d = mλ/2n, where m = 1, 2, 3, ..., for the intended EHD wavelength λ, where n is the refractive index of the medium diamond.
(2) The reflecting mirror reflection wavelength is optimized to the EHP wavelength. The cavity length d is determined at d = mλ/2n, where m = 1, 2, 3, ..., for the intended EHP wavelength λ, where n is the refractive index of the medium diamond.
(3) The end faces of the cavity are formed by etching. The cavity end faces can be formed by etching.
(4) The cavity end faces are a (111) cleaved plane. The cavity end faces can be formed by the cleavage of the (111) plane of the diamond.
(5) The cavity is formed by naturally formed planes of the diamond isolated particles. The cavity end faces can be formed by naturally formed planes of the isolated particles of the vapor phase synthetic diamond.
(6) The cavity is a diamond micro-sphere. It is known that the micro-spheres can form an optical cavity having a high quality factor (J. W. S. Rayleigh, "Theory of Sound vol. II", Dover Publication (New York), 1945). It is applicable to the diamond high brightness ultraviolet ray emitting element in accordance with the present invention.
(7) Cavity reflecting mirrors are formed by a dielectric multilayer film or an Al film. The cavity mirrors can be formed by the dielectric multilayer film or Al film.
(8) The cavity length is equal to or greater than 50 µm. The laser using the indirect band gap semiconductor is small in both the gain and loss in the medium. Accordingly, to reduce the effect of the reflection loss in the cavity mirrors, it is preferable that the cavity length be determined at 50 µm or longer.

The foregoing diamond high brightness ultraviolet ray emitting element can emit high-intensity ultraviolet rays with a single wavelength at high efficiency. The ultraviolet with the wavelength 230 - 250 nm has a small focusing spot diameter and a high spatial resolution. In addition, it has high chemical activity for biological tissue.

Exploiting these advantages, the foregoing diamond high brightness ultraviolet ray emitting element is applicable as the light source to bactericidal lamps, excitation of a fluorescent materials in lighting apparatus, information readers in optical disk drives, semiconductor lithography systems, semiconductor pattern test systems, and medical laser scalpels. As a result, it can implement a variety of much higher performance, lower cost, safer and simpler systems than the conventional system.

### [EMBODIMENT 1]

Fig.2 is a cross-sectional view showing an embodiment of the diamond high brightness ultraviolet ray emitting element in accordance with the present invention, which employs the EHP (electron-hole plasma) in a diamond isotope pin junction diode. In Fig.2, the reference numeral 1 designates a ¹²C i-type diamond substrate (substrate also serving as a heat sink); 2 designates a ¹³C n-type diamond layer formed on the ¹²C i-type diamond substrate 1; 3 designates a ¹²C i-type diamond layer (high-density phase constituting an emission layer) formed on the ¹³C n-type diamond layer 2; 4 designates a ¹³C p-type diamond layer formed on the ¹²C i-type diamond layer 3; 5 designates an Al mirror formed on the emitting side of the ¹²C i-type diamond layer 3 and ¹³C p-type diamond layer 4 to constitute the cavity; 6 designates an Al mirror formed on the opposite side of the Al mirror 5 to constitute the cavity; 7 designates an Au/Ti electrode formed on the ¹³C n-type diamond layer 2; 8 designates an Au/Ti electrode formed on the ¹³C p-type diamond layer 4; 9 designates an Al wire connected to the electrode 7; and 10 designates an Al wire connected to the electrode 8.

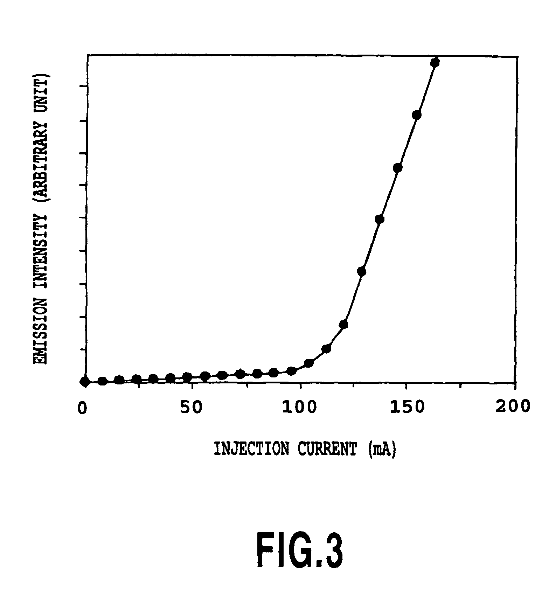

The individual diamond layers will be described below.
a) The sulfur-doped n-type CVD (Chemical Vapor Deposition) layer (¹³C n-type diamond layer 2).
   The substrate was composed of a high-pressure synthetic single crystal diamond with its (100) plane polished. The diamond synthesis was carried out by a microwave CVD system under the conditions of the MW output of 500 W and CH₄ concentration of 1.0% (diluted by H₂). As for gas chemical purity, the CH₄ was 99.9999%, H₂ was 99.99999%, and ¹³C isotope was 99%. The S source was H₂S with S/C being 5000 ppm. The temperature was 900°C, the growth duration was 100 min, and the film thickness was 1.0 µm.
b) The doping-free i-type CVD layer (¹²C i-type diamond layer 3).
   The diamond synthesis was carried out by the microwave CVD system under the conditions of the MW output of 750 W and CH₄ concentration of 0.025% (diluted by H₂). As for the gas chemical purity, the CH₄ was 99.9999%, H₂ was 99.99999%, and ¹²C isotope purity was 99.95%. The synthetic pressure was 25 Torr, temperature was 870°C, growth duration was 12 h, and film thickness was 0.1 µm.
c) The boron-doped p-type CVD layer (¹³C p-type diamond layer 4).
   The diamond synthesis was carried out by the microwave CVD system under the conditions of the MW output of 750 W and CH₄ concentration of 0.025% (diluted by H₂). As for the gas chemical purity, the CH₄ was 99.9999%, H₂ was 99.99999%, and ¹³C isotope purity was 99%. The B source was B(CH₃)₃ with B/C being 1000 ppm. The synthetic pressure was 25 Torr, temperature was 870°C, growth duration was 118 h, and film thickness was 1.5 µm.
d) As for the etching, RIE was used to form the 100 pm square pin junction diode.
e) As for the cavity mirror formation, the Al film cavity mirrors were formed on both side planes of the pin diode by the photolithography.
f) The electrodes were formed by Au coated Ti (Au/Ti).
   The Ti deposition was carried out by sputtering using the Ti target under the conditions of the Ar gas flow rate of 30 ml/min, the pressure of 5 mTorr, the substrate temperature of 200°C, the voltage of 700 V and the current of 1 A, thereby depositing the Ti with the film thickness of 500 Å in the duration of 4 min.
   The Au deposition was carried out by the sputtering using the Au target under the conditions of the Ar gas flow rate of 30 ml/min, the pressure of 5 mTorr, the substrate temperature of 200°C, the voltage of 700 V and the current of 1.5 A, thereby depositing the Au with the film thickness of 5000 Å in the duration of 10 min.
g) The characteristics (see, Fig.3)
   Fig.3 illustrates the relationships between the injection current and emission intensity of the thus fabricated pin junction diamond emitting element in the room temperature. Although the ordinary free exciton radiation was observed at a current equal to or less than 10 mA (current density 100 Acm⁻²), the spectra changed to the emission based on the EHP at the current equal to or greater than 10 mA, thereby being able to implement the high efficient ultraviolet emission. Furthermore, the emission intensity increased sharply at the current equal to or greater than 120 mA. Thus, the laser oscillation was confirmed, in which case, the current density was 1.2 KAcm⁻² and the emission wavelength was 239 nm.
   The nitrogen concentrations of the four layers (including the substrate) constituting the foregoing emitting element were all equal to or less than 10 ppm, and the boron concentration was equal to or less than 100 ppm. Incidentally, although the nitrogen doping performed into the insulating layer constituting the emission layer caused the EHP emission to be observed until the nitrogen concentration in the crystal reaches 10 ppm, the EHP emission was not observed at 15 ppm. In addition, although the boron doping carried out into the insulating layer caused the EHP emission to be observed until the boron concentration reaches 80 ppm, the EHP emission was not observed at 120 ppm.

### [Embodiment 2]

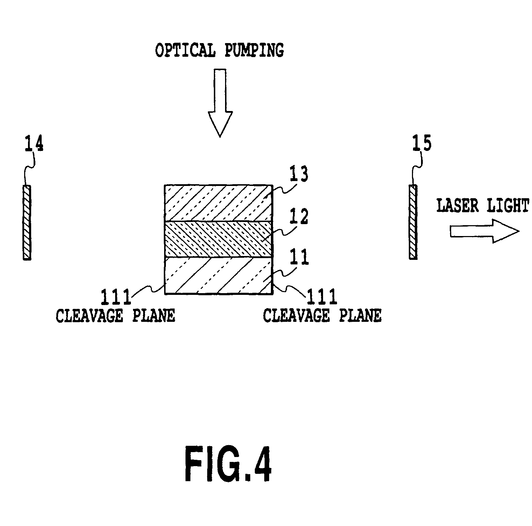

Fig.4 is a cross-sectional view showing another embodiment of the diamond high brightness ultraviolet ray emitting element in accordance with the present invention, which employs the EHD (electron-hole droplets) in a diamond isotope pn junction diode. In Fig. 4, the reference numeral 11 designates a ¹²C i-type diamond substrate (substrate also serving as a heat sink); 12 designates an n-type diamond layer formed on the ¹²C i-type diamond substrate 11; 13 designates a p-type diamond layer formed on the n-type diamond layer 12; and the reference numerals 14 and 15 designate external cavity mirrors provided outside the diamond layer. A section close to the carrier depletion layer of the pn junction constitute an emission layer with the high-density phase.
a) The phosphorus-doped n-type CVD layer (n-type diamond layer 12).
   The substrate was composed of a high-pressure synthetic single crystal diamond with its (100) plane polished, and had a size of 2 × 2 × 0.5 mm³. The diamond synthesis was carried out by a microwave CVD system under the conditions of the MW output of 500 W and CH₄ concentration (natural isotope composition ratio) of 1.0% (diluted by H₂). As for gas chemical purity, the CH₄ was 99.9999%, and H₂ was 99.99999%. The P source was P(CH₃)₃ with P/C being 1000 ppm. The temperature was 900°C, the growth duration was 100 min, and the film thickness was 1.0 µm.
b) The boron-doped p-type CVD layer (p-type diamond layer 13).
   The diamond synthesis was carried out by the microwave CVD system under the conditions of the MW output of 750 W and CH₄ concentration (natural isotope composition ratio ) of 0.025% (diluted by H₂). As for the gas chemical purity, the CH₄ was 99.9999%, and H₂ was 99.99999%. The B source was B(CH₃)₃ with B/C being 1000 ppm. The temperature was 870°C, growth duration was 118 h, and film thickness was 1.5 µm.
c) Installation of the cavity mirrors.
   The cleavage of the (111) planes were performed for the entire substrate, and the emitting element including a 400 µm square pn junction was fabricated. In parallel with the cleaved planes, two dielectric multilayer film-coated flat mirrors were installed 5 cm apart. The entire device was maintained at 120 K by liquid nitrogen cooling.
d) Characteristics.
   The thus fabricated pn junction-type diamond emitting element was irradiated by the fifth harmonic of an Nd:YAG laser (wavelength 213 nm and pulse width 40 ps) at a repetition frequency of 10 Hz. The ordinary free exciton radiation was observed at the excitation intensity equal to or less than 10 mJ/shot (excitation intensity 1.8 × 10¹¹ Wcm⁻²). However, at the excitation intensity beyond that, the spectra were changed to the EHD emission with increasing the emission efficiency. In addition, at the excitation intensity equal to or greater than 80 mJ/shot, the emission intensity increased sharply, and the laser oscillation was confirmed at a wavelength of 240 nm.
   The nitrogen concentrations of the three layers (including the substrate) constituting the foregoing emitting element were all equal to or less than 10 ppm, and the boron concentrations were equal to or less than 100 ppm. Although the boron doping carried out into the p-type layer caused the EHD emission to be observed up to the boron concentration of 80 ppm, the EHD emission was not observed at 120 ppm.

### INDUSTRIAL APPLICABILITY

As described above, according to the present invention, the carrier high-density phase formed by subjecting the diamond crystal to the high-density excitation is used as the light-emitting mechanism. The combination of the high-quality diamond with the high-density excitation can implement the device having the stable carrier high-density phase and the emission efficiency higher than the conventional device with a low-density excitation.

In addition, since the carrier high-density phase of the diamond has an optical gain, the device can operate as an ultraviolet laser.

## Claims

1. A diamond high brightness ultraviolet ray emitting element **characterized by** comprising as a light-emitting structure a carrier high-density phase which is formed by subjecting a diamond crystal to high-density excitation.

2. The diamond high brightness ultraviolet ray emitting element as claimed in claim 1, **characterized in that** the high-density excitation has an intensity equal to or greater than 10²⁰ cm⁻³ in terms of a carrier density, or equal to or greater than 100 Acm⁻² in terms of a current density.

3. The diamond high brightness ultraviolet ray emitting element as claimed in claim 1 or 2, **characterized in that** a region for carrying out the high-density excitation is spatially limited to an area equal to or less than 0.01 cm².

4. The diamond high brightness ultraviolet ray emitting element as claimed in claim 3, **characterized in that** the region for carrying out the high-density excitation is formed by etching.

5. The diamond high brightness ultraviolet ray emitting element as claimed in claim 3, **characterized in that** the spatial restriction of the region for carrying out the high-density excitation is formed by diamond isolated particles.

6. The diamond high brightness ultraviolet ray emitting element as claimed in any one of claims 1-5, further **characterized by** comprising a structure for controlling temperature equal to or lower than 170 K when using electron-hole droplets, and equal to or higher than 160 K when using electron-hole plasma.

7. The diamond high brightness ultraviolet ray emitting element as claimed in any one of claims 1-6, further **characterized by** comprising a spatial confinement structure of the carriers.

8. The diamond high brightness ultraviolet ray emitting element as claimed in claim 7, **characterized in that** the spatial confinement structure of the carriers comprises a stack of layers including at least two layers with different electric characteristics.

9. The diamond high brightness ultraviolet ray emitting element as claimed in claim 7 or 8, **characterized in that** the spatial confinement structure of the carriers comprises one of a pn junction and a pin junction.

10. The diamond high brightness ultraviolet ray emitting element as claimed in claim 9, **characterized in that** the one of the pn junction and the pin junction comprises a p-type layer composed of a boron-doped diamond.

11. The diamond high brightness ultraviolet ray emitting element as claimed in claim 9, **characterized in that** the one of the pn junction and the pin junction comprises an n-type layer composed of a phosphorus-doped diamond or sulfur-doped diamond.

12. The diamond high brightness ultraviolet ray emitting element as claimed in any one of claims 9-11, **characterized in that** the one of the pn junction and the pin junction comprises electrodes formed on the p-type layer and the n-type layer.

13. The diamond high brightness ultraviolet ray emitting element as claimed in claim 12, **characterized in that** said electrodes are composed of titanium.

14. The diamond high brightness ultraviolet ray emitting element as claimed in any one of claims 1-13, **characterized in that** isotope composition ratio of at least part of the diamond is controlled.

15. The diamond high brightness ultraviolet ray emitting element as claimed in claim 14, **characterized in that** purity of ¹²C or ¹³C is controlled equal to or greater than 90% in the control of the isotope composition ratio of the diamond.

16. The diamond high brightness ultraviolet ray emitting element as claimed in claim 7 or 8, **characterized in that** the confinement structure is formed by introducing crystal defects into a region of the crystal by at least one of methods consisting of an impurity doping, neutron beam irradiation, and distortion introduction.

17. The diamond high brightness ultraviolet ray emitting element as claimed in any one of claims 1-16, **characterized by** comprising a diamond substrate that functions as a heat sink.

18. The diamond high brightness ultraviolet ray emitting element as claimed in any one of claims 1-17, **characterized in that** the diamond crystal has a nitrogen concentration equal to or less than 10 ppm.

19. The diamond high brightness ultraviolet ray emitting element as claimed in any one of claims 1-18, **characterized in that** the diamond crystal has a boron concentration equal to or less than 100 ppm.

20. The diamond high brightness ultraviolet ray emitting element as claimed in any one of claims 1-19, further **characterized by** comprising an optical cavity, and operating as a laser.

21. The diamond high brightness ultraviolet ray emitting element as claimed in claim 20, **characterized in that** a reflection wavelength of reflecting mirrors constituting said optical cavity, and a cavity length are optimized for an emission wavelength of EHD or EHP.

22. The diamond high brightness ultraviolet ray emitting element as claimed in claim 20 or 21, **characterized in that** said optical cavity comprises reflecting mirror planes formed by etching.

23. The diamond high brightness ultraviolet ray emitting element as claimed in claim 20 or 21, **characterized in that** said optical cavity comprises reflecting mirror planes formed by a (111) cleaved plane.

24. The diamond high brightness ultraviolet ray emitting element as claimed in claim 20 or 21, **characterized in that** said optical cavity comprises reflecting mirror planes formed by naturally formed plane of isolated particles.

25. The diamond high brightness ultraviolet ray emitting element as claimed in anyone of claims 20-24, **characterized in that** said cavity is composed of micro-spheres.

26. The diamond high brightness ultraviolet ray emitting element as claimed in any one of claims 20-25, **characterized in that** said optical cavity comprises reflecting mirrors composed of an Al film.

27. The diamond high brightness ultraviolet ray emitting element as claimed in any one of claims 20-25, **characterized in that** said optical cavity comprises reflecting mirrors composed of a dielectric multilayer film.

28. A bactericidal lamp that employs the diamond high brightness ultraviolet ray emitting element as defined in any one of claims 1-27 as a light source.

29. A lighting system that employs the diamond high brightness ultraviolet ray emitting element as defined in any one of claims 1-27 as a pumping source for fluorescent materials.

30. An optical disk drive that employs the diamond high brightness ultraviolet ray emitting element as defined in any one of claims 1-27 as a light source for reading information.

31. A semiconductor lithographic exposure system that employs the diamond high brightness ultraviolet ray emitting element as defined in any one of claims 1-27 as a light source.

32. A semiconductor pattern test system that employs the diamond high brightness ultraviolet ray emitting element as defined in any one of claims 1-27 as a light source.

33. A medical laser scalpel system that employs the diamond high brightness ultraviolet ray emitting element as defined in any one of claims 1-27 as a light source.
